# EUROPEAN PATENT APPLICATION

(11) **EP 4 447 127 A1**
(43) Date of publication of application: **16.10.2024**
(21) Application number: 22902878.2
(22) Date of filing: 18.08.2022
(51) Int. Cl.: H01L 31/0232, H01L 31/0352, H01L 31/105

(54) **PHOTODETECTOR**

(30) Priority: 06.12.2021 CN 202111478684
(71) Applicant: Innolight Technology (Suzhou) Ltd., Suzhou, Jiangsu 215000 (CN)
(72) Inventor: WU, Hao, Suzhou, Jiangsu 215000 (CN); ZHENG, Xuezhe, Suzhou, Jiangsu 215000 (CN)
(74) Representative: Becker, Eberhard
(86) International application number: PCT/CN2022/113315
(87) International publication number: WO 2023/103444

(57) **Abstract**

The present application relates to the technical field of integrated circuits, and in particular to a photodetector. The photodetector comprises: a waveguide layer; an absorption layer, the absorption layer being located on the upper surface of the waveguide layer or at least partially embedded in the waveguide layer; and a cladding material, the cladding material covering the tops and sidewalls of the waveguide layer and the absorption layer; wherein at least one end face of the photodetector is a light incident surface, and the thickness of the end face of the absorption layer close to the light incident surface is smaller than the thicknesses of remaining portion. According to the present application, since the thickness of the end face of the absorption layer close to the light incident surface is smaller than the thicknesses of the remaining portion, the light energy absorbed by the portion close to the light incident surface is less than the light energy absorbed by the remaining portion of the absorption layer, thereby reducing the degree of aggregation of photon-generated carriers in an intrinsic region of the photodetector, increasing the electric field intensity of a photon-generated carrier aggregation region, reducing the influence of large-light input on the bandwidth and responsivity performance of the photodetector, and finally improving a large-light input threshold of the photodetector.

## Description

### Technical Field

The present application relates to the technical field of integrated circuits, and in particular to a photoelectric detector.

### Technical Background

The current development of the Internet, the emergence of massive content, and the deployment and application of 5G networks have placed increasing demands on communication speed and capacity. Photoelectric detectors are devices that convert high-speed optical signals into electrical signals, and the technical indicators thereof such as bandwidth, responsivity, and saturated optical power have also been improved accordingly. On the one hand, according to Shannon's theorem, higher communication rates require larger detector bandwidths; on the other hand, different application scenarios and different transmitters need to communicate with each other, requiring the receiver to operate within a certain input optical power range.

The bandwidth of common PIN photoelectric detectors is limited by two factors: 1. the parasitic capacitance and resistance of the detector; 2. the transit time of photogenerated carriers in the intrinsic area of the detector. To reduce parasitic capacitance and increase bandwidth without affecting responsivity, the photoelectric detector has to reduce the area of the PIN junction area and increase the width of the area. The widening of the intrinsic area leads to the weakening of the internal electric field, the drift speed of photogenerated carriers in the electric field is slowed down and the transit time is increased. What is serious is that when the incident light energy increases, the number of photogenerated carriers increases and accumulates in the PIN junction. The electric field generated by the carriers weakens the drift electric field in the PIN junction, which further increases the transit time of the photogenerated carriers. The performance of the photoelectric detector is that when the incident light energy increases and exceeds a certain threshold, the detector bandwidth decreases, and when the light continues to increase, the detector responsivity decreases.

In summary, how to increase the bright light input threshold of the detector has become a technical problem that needs to be solved by people in this technical field.

### Invention Summary

### Technical Problem

Based on above, in order to address the problems in the related art, it is necessary to provide a photoelectric detector that reduces the impact of bright light input on the detector bandwidth and responsivity performance, and ultimately improves the bright light input threshold of the detector.

### Plan for Solving Problem

### Plan for Solving Technical Problem

In order to achieve the above purpose, the present invention provides a photoelectric detector, and the photoelectric detector includes:

A waveguide layer is provided.

An absorption layer is provided, and the absorption layer is located on an upper surface of the waveguide layer or is at least partially embedded in the waveguide layer.

A cladding material is provided, and the cladding material covers the top portions and side walls of the waveguide layer and the absorption layer.

In the disclosure, at least one end surface of the photoelectric detector is a light incident surface, and a thickness of an end surface of the absorption layer adjacent to the light incident surface is smaller than a thickness of other portions.

In one of the embodiments, a thickness of the waveguide layer is greater than a thickness of the cladding material.

In one of the embodiments, the width of the end surface of the absorption layer adjacent to the light incident surface is smaller than the width of other portions of the absorption layer.

In one of the embodiments, the width of the end surface of the waveguide layer adjacent to the light incident surface is greater than the width of other portions of the waveguide layer.

In one of the embodiments, an orthographic projection of the absorption layer on the upper surface of the waveguide layer is at least partially located within the upper surface of the waveguide layer.

In one of the embodiments, the orthographic projection of the absorption layer on the upper surface of the waveguide layer is located within the upper surface of the waveguide layer, and the center line of the absorption layer deviates from the center line of the waveguide layer.

In one of the embodiments, the orthographic projection of the absorption layer on the upper surface of the waveguide layer is partially located within the upper surface of the waveguide layer, and the center line of the absorption layer deviates from the center line of the waveguide layer.

In one of the embodiments, the waveguide layer is inclined at a preset angle with respect to the extending direction of the absorption layer.

In one of the embodiments, the end surface of the waveguide layer adjacent to the light incident surface is formed in a step shape.

In one of the embodiments, the absorption layer includes:

A first absorption layer and a second absorption layer are provided, the first absorption layer and the second absorption layer are integrally connected, and the first absorption layer is located between the second absorption layer and the light incident surface; the light energy absorption rate of the first absorption layer is lower than the light energy absorption rate of the second absorption layer.

In one of the embodiments, the light energy absorption rate of the absorption layer gradually increases from the light incident surface toward a direction away from the light incident surface.

In one of the embodiments, the waveguide layer includes:

A first waveguide layer and a second waveguide layer are provided, the second waveguide layer is embedded in the first waveguide layer, an upper surface of the second waveguide layer is higher than an upper surface of the first waveguide layer, and the absorption layer is located on the upper surface of the second waveguide layer or is at least partially embedded in the second waveguide layer.

### Beneficial Effects of Invention

### Beneficial Effects

The absorption layer of the photoelectric detector is located on the waveguide layer or at least partially embedded in the waveguide layer, and the cladding material covers the top portions and side walls of the waveguide layer and the absorption layer; in which at least one end surface of the photoelectric detector is a light incident surface, and a thickness of an end surface of the absorption layer adjacent to the light incident surface is smaller than a thickness of other portions. In the present application, since a thickness of an end surface of the absorption layer adjacent to the light incident surface is smaller than a thickness of other portions, light energy absorbed by the portion adjacent to the light incident surface is smaller than light energy absorbed by other portions of the absorption layer, the concentration of photogenerated carriers in the intrinsic area of the photoelectric detector is reduced, the electric field strength in the photogenerated carrier concentration area is increased, the impact of bright light input on the bandwidth and responsivity performance of the photoelectric detector is reduced, and ultimately the bright light input threshold of the photoelectric detector is increased.

### BRIEF DESCRIPTION OF DRAWINGS

### DESCRIPTION OF DRAWINGS

In order to more clearly illustrate the technical solutions in the embodiments of the present application or the conventional technology, the drawings required for use in the embodiments or the conventional technology descriptions are briefly introduced below. Certainly, the drawings described below are only some embodiments of the present application. For ordinary technicians in this field, other drawings may be obtained based on these drawings without creative work.
FIG. 1 is a schematic structural diagram of a detector.
FIG. 2 is a schematic diagram showing a comparison of absorption curves of a photoelectric detector of the present application, the detector in FIG. 1, and an ideal detector along the light wave transmission direction; in the diagram, a curve (1) is the absorption curve of the photoelectric detector of the present application along the light wave transmission direction, a curve (2) is the absorption curve of the detector in FIG. 1 along the light wave transmission direction, and a curve (3) is the absorption curve of the ideal detector along the light wave transmission direction.
FIG. 3 to FIG. 6 are schematic structural diagrams of longitudinal-sections of photoelectric detectors provided in different embodiments of the present application.
FIG. 7 to FIG. 21 are schematic structural diagrams of cross-sections of photoelectric detectors provided in different embodiments of the present application.

### Reference Signs List:

100, cladding material; 200, waveguide layer; 201, second gradient portion; 202, second straight portion; 203, second waveguide layer; 204, first waveguide layer; 300, absorption layer; 301, first gradient portion; 302, first straight portion; 303, first absorption layer; 304, second absorption layer.

### Embodiments of Invention

### Embodiments of the Invention

To facilitate understanding of the present application, the present application will be described more comprehensively below with reference to the relevant drawings. Embodiments of the present application are shown in the accompanying drawings. However, the present application may be implemented in many different forms and is not limited to the embodiments described herein. On the contrary, the purpose of providing these embodiments is to make the disclosure of this application more thorough and complete.

Unless defined otherwise, all technical and scientific terms used herein have the same meaning as commonly understood by persons of ordinary skill in the art to which this application belongs. The terms used herein in the specification of the present application are only for the purpose of describing specific embodiments and the embodiments are not intended to limit the present application.

It should be understood that when an element or layer is referred to as being "on," "adjacent to," "connected to" or "coupled to" another element or layer, the element or layer may be directly on, adjacent to, connected or coupled to the other element or layer, or intervening elements or layers may be present. On the contrary, when an element is referred to as being "directly on," "directly adjacent to," "directly connected to," or "directly coupled to" another element or layer, there are no intervening elements or layers present. It should be understood that although the terms, for example, first, second, third may be used to describe various elements, components, areas, layers, doping types and/or portions, these elements, components, areas, layers, doping types and/or portions should not be limited by these terms. These terms are only used to distinguish one element, component, area, layer, doping type, or portion from another element, component, area, layer, doping type, or portion. Therefore, without departing from the teachings of the present invention, the first element, component, area, layer, doping type, or portion discussed below may be referred to as a second element, component, area, layer, or portion; for example, the first doping type may be referred to as the second doping type, and similarly, the second doping type may be referred to as the first doping type; the first doping type and the second doping type are different doping types. For example, the first doping type may be P-type and the second doping type may be N-type, or the first doping type may be N-type and the second doping type may be P-type.

Spatially relative terms such as "below," "beneath," "below," "under," "above," "up above," may be used herein to describe the relationship of one element or feature to other elements or features shown in the figures. It should be understood that the spatially relative terms are intended to encompass different orientations of the device in use and operation in addition to the orientation depicted in the figures. For example, if the device in the figures is turned over, then elements or features described as "below" or "beneath" or "under" other elements would then be oriented "above" the other elements or features. Thus, the exemplary terms "below" and "beneath" may encompass both orientations of above and below. Furthermore, the devices may be included in alternative orientations (for example, rotated 90 degrees or other orientations) and the spatial descriptors used herein are interpreted accordingly.

As used herein, the singular forms "a", "an" and "the" may include the plural forms as well, unless the context clearly indicates otherwise. It should also be understood that the terms "include/comprises" or "having" and the like specify the presence of stated features, entireties, steps, operations, components, portions, or combinations thereof, but do not exclude the possibility of the presence or addition of one or more other features, entireties, steps, operations, components, portions, or combinations thereof. Meanwhile, in this specification, the term "and/or" includes any and all combinations of the relevant listed items.

Embodiments of the invention are described herein with reference to cross-sectional illustrations of schematic diagrams of idealized embodiments (and intermediate structures) of the invention, and in this way, variations in shapes of the illustrations as a result, for example, of manufacturing techniques and/or tolerances are to be expected. Thus, embodiments of the present invention should not be limited to the particular shapes of areas illustrated herein but are to include deviations in shapes as a result, for example, of manufacturing techniques. For example, an implanted area illustrated as a rectangle will, typically, have rounded or curved features and/or a gradient of implant concentration at the edges thereof rather than a binary change from implanted to non-implanted area. Likewise, a buried region formed by implantation may result in some implantation in an region between the buried region and the surface through which the implantation takes place. Thus, the areas illustrated in the figures are schematic in nature and the shapes thereof are not intended to illustrate the actual shape of a area of a device and are not intended to limit the scope of the present invention.

One solution to the problem of bright light bandwidth and responsivity attenuation is to increase the bias voltage loaded on the PIN detector, thereby enhancing the electric field strength in the intrinsic area to weaken the effect of a large number of photogenerated carriers on the electric field. The problems with this approach are: 1. The requirements for TIA (Trans-impedance amplifier) or external power supply are increased, to meet the bandwidth requirements under bright light conditions, SiGe detectors require a bias voltage of more than 3V, and InP detectors even requires more than 5V, which is inconsistent with the future development trend of CMOS integration. 2. Under large bias voltage, the dark current of the detector increases, and the noise generated also increases accordingly. At the same time, the high electric field makes more defects in SiGe or InP materials be excited, which accelerates aging during continuous operation and shortens the life of the device.

Another solution to the problem of bright light bandwidth and responsivity attenuation is to divide the received light into several beams and input the beams into several different detectors or different areas of the detector to reduce the number of photogenerated carriers generated in the incident area of the detector and reduce the electric field effect on the intrinsic area; the incident light is divided into 2 and 4 beams and input them into 1 and 2 detectors respectively, and the bright light input attenuation thresholds of the detectors may be improved by 3dB and 6dB respectively. The problems with this solution are: 1. When the light entering from an end of the detector passes through the absorption area and is not completely absorbed, the light is output from another end and return to the transmission link along the input optical path of the other end, resulting in a low return loss at the receiving end of the entire receiving system, affecting the entire transmission link. 2. When light is divided into multiple beams and multiple detectors are connected in parallel, time delays are likely to occur between the output electrical signals of different detectors, which also affects the overall bandwidth of the detectors and the performance of the receiving system. 3. When multiple detectors are connected in parallel, the yield and reliability of the receiving chip decrease as the number of detectors increases.

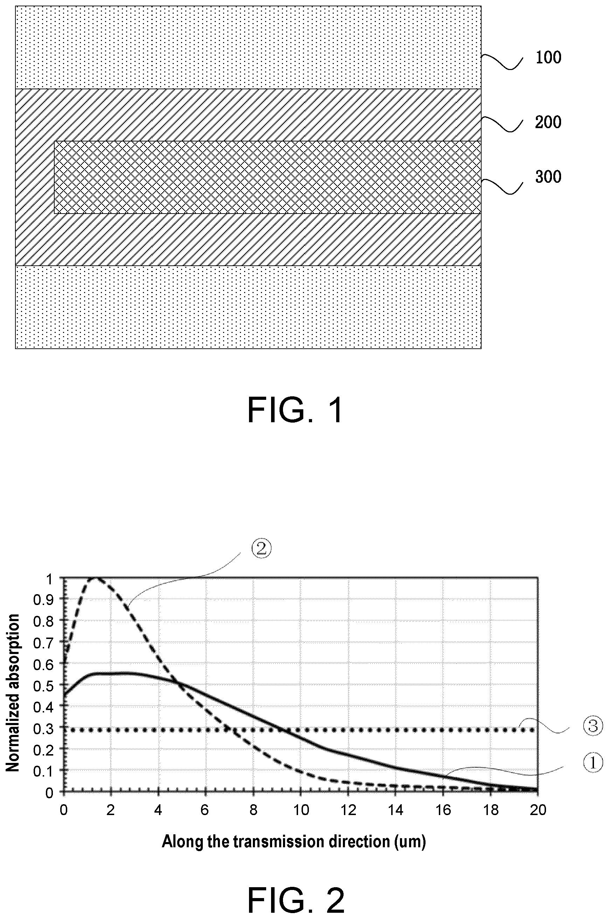

There is a solution to simultaneously solve the bright light bandwidth attenuation and the signal delay of multiple detectors. Multiple detectors are connected in parallel using electrodes of transmission line structure, and the signal delay is controlled by input waveguide length, thereby achieving complete synchronization of the electrical signals of multiple detectors. The problem with this solution is that the electrode structure design is complex, the process requirements are strict, and the application remains unchanged. Similarly, this solution cannot solve the problem of return loss at the receiving end caused by incomplete absorption of light by the detector, and the problem of reduced yield and reliability caused by the increase in the number of detectors. As shown in FIG. 1, ordinary photoelectric detectors are designed with consistent cross sections along the transmission direction of the light. Therefore, the absorption coefficient is the same on each cross-section for the light, as a result, after the light enters the photoelectric detector, the front end absorbs more light energy, while the back end absorbs less light energy as the total light energy decreases. As shown by the dotted line in FIG. 2, further, the result comprises that more photogenerated carriers are distributed at the front end of the detector and less at the back end. This application changes the transmission and absorption distribution of light waves in the photoelectric detector through structural and material design, reducing the light energy absorbed at the front end of the detector, as shown by the solid line in FIG. 2, which reduces the concentration of photogenerated carriers in local areas, the impact thereof on the electric field is reduced, thereby the bright light input threshold of the detector is increased.

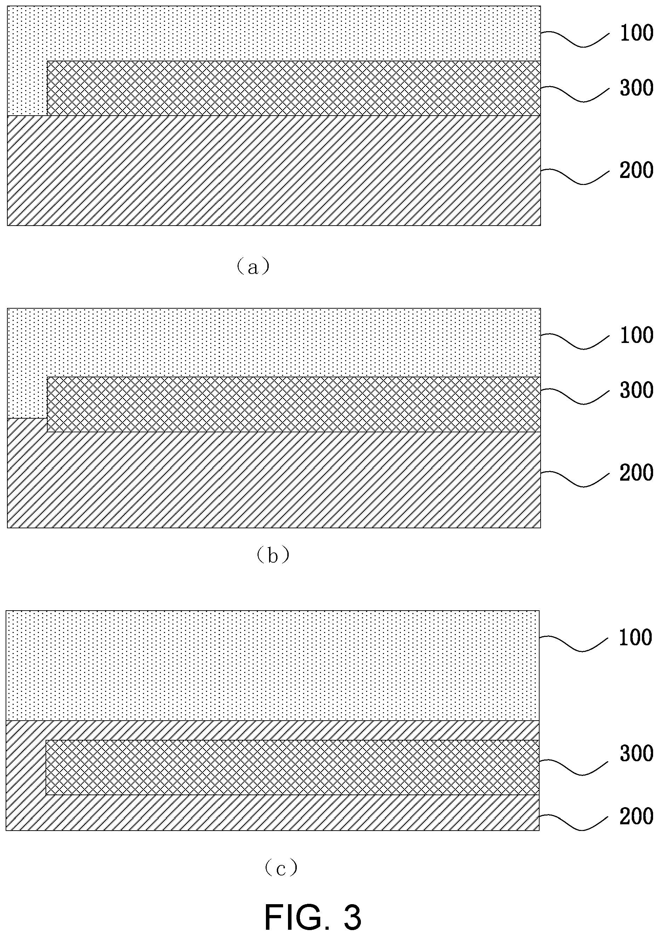

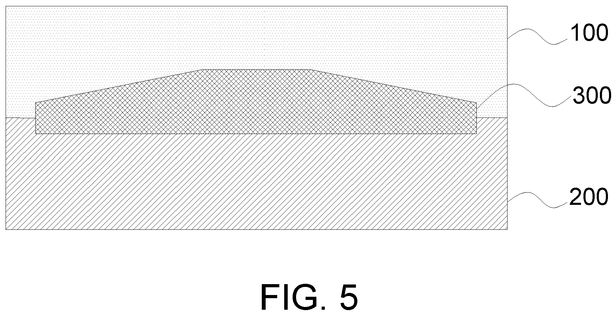

As shown in FIG. 3, FIG. 4, and FIG. 5, the present invention provides a photoelectric detector, FIG. 3, FIG. 4, and FIG. 5 are schematic structural diagrams of longitudinal-sections of a photoelectric detector of the invention, and the photoelectric detector includes: a waveguide layer 200, an absorption layer 300, and a cladding material 100. The absorption layer 300 is located on an upper surface of the waveguide layer 200 or is at least partially embedded in the waveguide layer 200; the cladding material 100 covers the top portions and sidewalls of the waveguide layer 200 and the absorption layer 300; at least one end surface of the photoelectric detector is a light incident surface, and a thickness of an end surface of the absorption layer 300 adjacent to the light incident surface is smaller than a thickness of other portions.

In an example, the waveguide layer 200 is used to guide the transmission of light waves, and the absorption layer 300 is located on an upper surface of the waveguide layer 200, as shown in (a) of FIG. 3; in another example, the absorption layer 300 may also be partially embedded in the waveguide layer 200, as shown in (b) of FIG. 3; in still another example, the absorption layer 300 may also be entirely embedded in the waveguide layer 200, as shown in (c) of FIG. 3.

Specifically, the absorption layer 300 absorbs light waves, generates carriers, and forms a photocurrent; the cladding material 100 covers the top portions and side walls of the waveguide layer 200 and the absorption layer 300 to protect the waveguide layer 200 and the absorption layer 300. The thickness of the end surface of the absorption layer 300 adjacent to the light incident surface is smaller than the thickness of other portions.

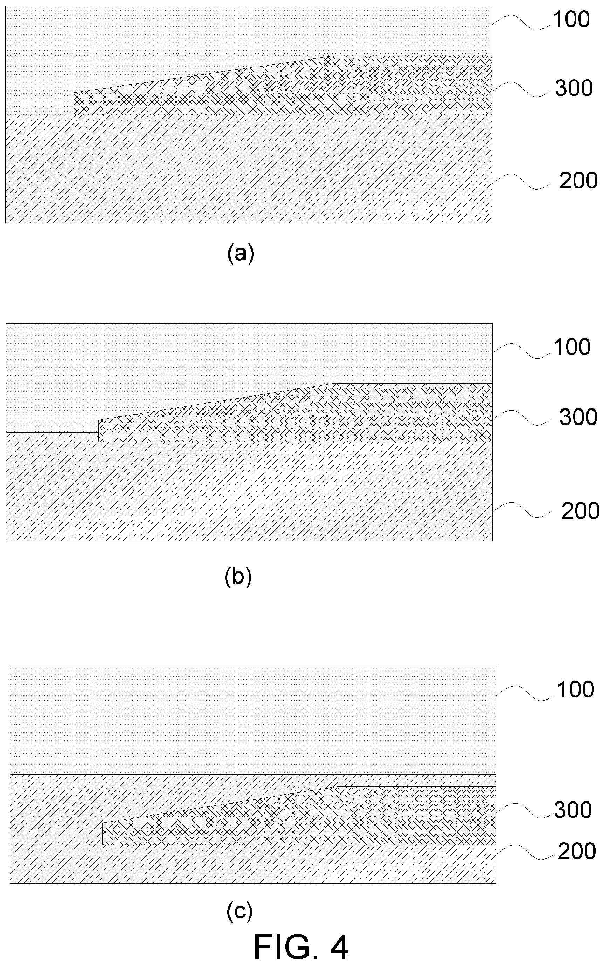

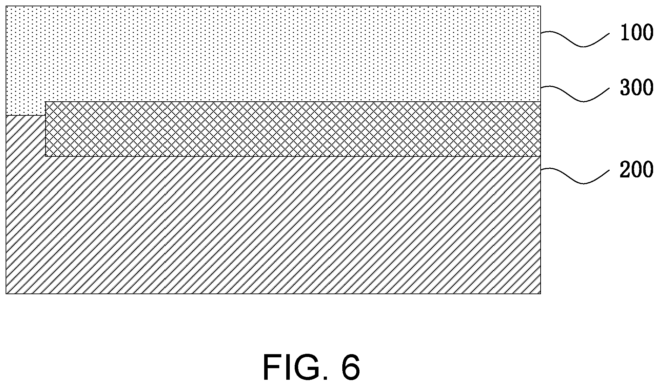

More specifically, the waveguide layer 200 is used to guide the transmission of light waves, and the absorption layer 300 is located on the upper surface of the waveguide layer 200, as shown in (a) of FIG. 4; in another example, the absorption layer 300 may also be partially embedded in the waveguide layer 200, as shown in (b) of FIG. 4; in still another example, the absorption layer 300 may also be entirely embedded in the waveguide layer 200, as shown in (c) of FIG. 4. A structural schematic diagram of the longitudinal cross-section when both end surfaces of the photoelectric detector are light incident surfaces is shown in FIG. 6.

Specifically, through changing the thickness of the end surface of the absorption layer 300 adjacent to the light incident surface, the present invention provides a photoelectric detector that changes the transmission and absorption distribution of light waves in the photoelectric detector, reducing the light energy absorbed at the front end of the photoelectric detector, as shown by the solid line in FIG. 2, which reduces the concentration of photogenerated carriers in local areas, and the impact thereof on the electric field is reduced, thereby the bright light input threshold of the detector is increased. The invention avoids the problem of ordinary photoelectric detectors being designed with consistent cross sections along the transmission direction of the light wave, so that the light energy absorbed is the same on each cross-section for the light wave, as a result, after the light wave enters the photoelectric detector, the front end absorbs more light energy, while the back end absorbs less light energy as the total light energy decreases, further, the result comprises that more photogenerated carriers are distributed at the front end of the detector and less at the back end.

As shown in FIG. 6, in one of the embodiments, the thickness of the waveguide layer 200 may be greater than the thickness of the cladding material 100.

Specifically, in the embodiment where the thickness of the waveguide layer 200 may be greater than the thickness of the cladding material 100, a configuration may be that the absorption layer 300 is located on the upper surface of the waveguide layer 200 or at least partially embedded in the waveguide layer 200, and may be that the thickness of the end surface of the absorption layer 300 adjacent to the light incident surface is smaller than the thickness of other portions. Through increasing the thickness of the waveguide layer 200, after the light wave is incident on the photoelectric detector, the distribution of the light field moves downward. When the light wave enters the absorption layer 300 from the waveguide layer 200, due to the increase in the thickness of the waveguide layer 200, the interaction distance between the waveguide layer 200 and the absorption layer 300 increases and the effect weakens. Therefore, the light energy absorbed by the front end is reduced, the number of photogenerated carriers distributed is reduced, and on the light wave transmission path, light absorption and carriers generated are uniformly distributed, thereby the bright light input threshold of the photoelectric detector is improved.

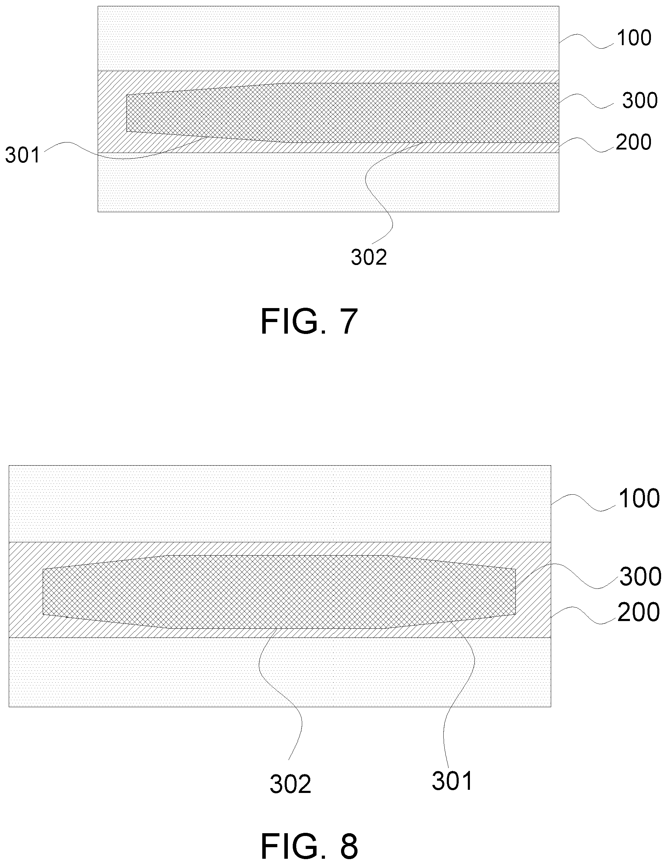

On the basis of FIG. 3 to FIG. 6, as shown in FIG. 7 and FIG. 8, in one of the embodiments, the width of the end surface of the absorption layer 300 adj acent to the light incident surface is smaller than the width of other portions of the absorption layer 300.

Specifically, the width of the end surface of the absorption layer 300 adjacent to the light incident surface is smaller than the width of other portions of the absorption layer 300, and the absorption layer 300 may be divided into a first gradient portion 301 and a first straight portion 302, in which the first gradient portion 301 and the first straight portion 302 are an integrated structure. The width of the first gradient portion 301 gradually increases from the end surface adjacent to the light incident surface along a direction away from the light incident surface until the width becomes the same as the width of the first straight portion 302.

Furthermore, at least one end surface of the photoelectric detector is a light incident surface. When an end surface of the detector is a light incident surface, the absorption layer 300 may be divided into the first gradient portion 301 and the first straight portion 302, as shown in FIG. 7; when two end surfaces of the detector are light incident surfaces, two ends of the first straight portion 302 of the absorption layer 300 are respectively disposed with the first gradient portions 301, as shown in FIG. 8.

In the above embodiment, the shape of the absorption layer 300 of the photoelectric detector adjacent to the light incident surface is changed, and a smaller width of the absorption layer 300 is used at the light incident surface that first contacts the light wave, so that the light energy absorbed by the adjacent light incident surface is reduced, as a result, the number of photogenerated carriers distributed is reduced. At the back end, as the total light energy is reduced, the width of the absorption layer 300 is widened to increase absorption, so that on the light wave transmission path, the light absorption and carriers generated are uniformly distributed, thereby the bright light input threshold of the photoelectric detector is improved.

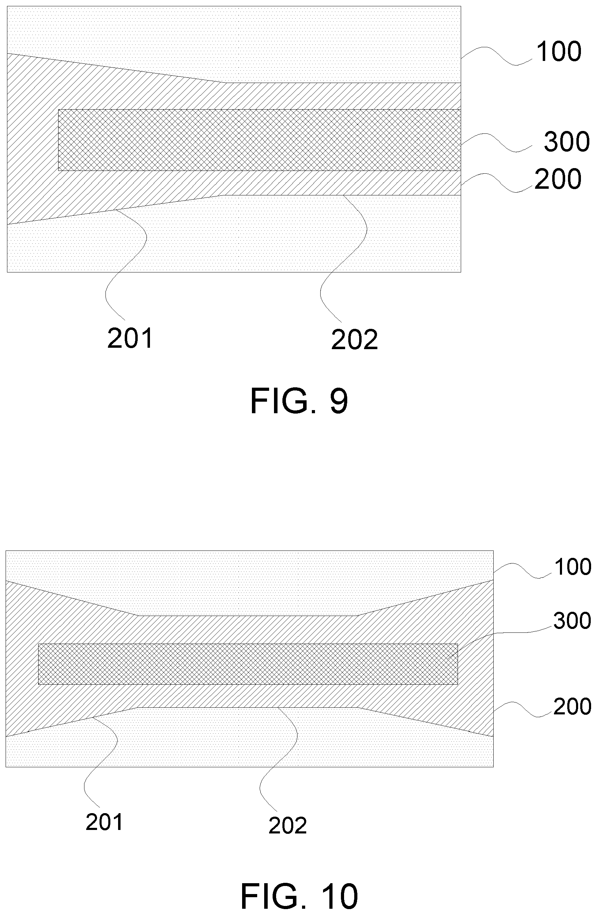

On the basis of FIG. 3 to FIG. 6, as shown in FIG. 9 and FIG. 10, in one of the embodiments, the width of the end surface of the waveguide layer 200 adj acent to the light incident surface is greater than the width of other portions of the waveguide layer 200.

Specifically, the width of the end surface of the waveguide layer 200 adj acent to the light incident surface is greater than the width of other portions of the waveguide layer 200. The waveguide layer 200 may be divided into a second gradient portion 201 and a second straight portion 202, in which the second gradient portion 201 and the second straight portion 202 are an integrated structure. The width of the end surface of the second gradient portion 201 gradually decreases from the end surface adjacent to the light incident surface along a direction away from the light incident surface until the width becomes the same as the width of the second straight portion 202.

Furthermore, at least one end surface of the photoelectric detector is a light incident surface. When an end surface of the detector is a light incident surface, the waveguide layer 200 may be divided into the second gradient portion 201 and the second straight portion 202, as shown in FIG. 9; when two end surfaces of the detector are light incident surfaces, two ends of the second straight portion 202 of the waveguide layer 200 are respectively disposed with the first gradient portions 301, as shown in FIG. 10.

In the above embodiment, the shape of the waveguide layer 200 adjacent to the light incident surface of the photoelectric detector is changed, and a larger width of the waveguide material is used at the front end that first contacts the light wave to reduce the contact between the light field and the absorption material, so that the light energy absorbed by the light incident surface is reduced, as a result, the number of photogenerated carriers distributed is reduced. At the back end, as the total light energy is reduced, the width of the waveguide material is reduced to increase absorption, so that on the transmission path, the light absorption and carriers generated are uniformly distributed, thereby the bright light input threshold of the detector is improved.

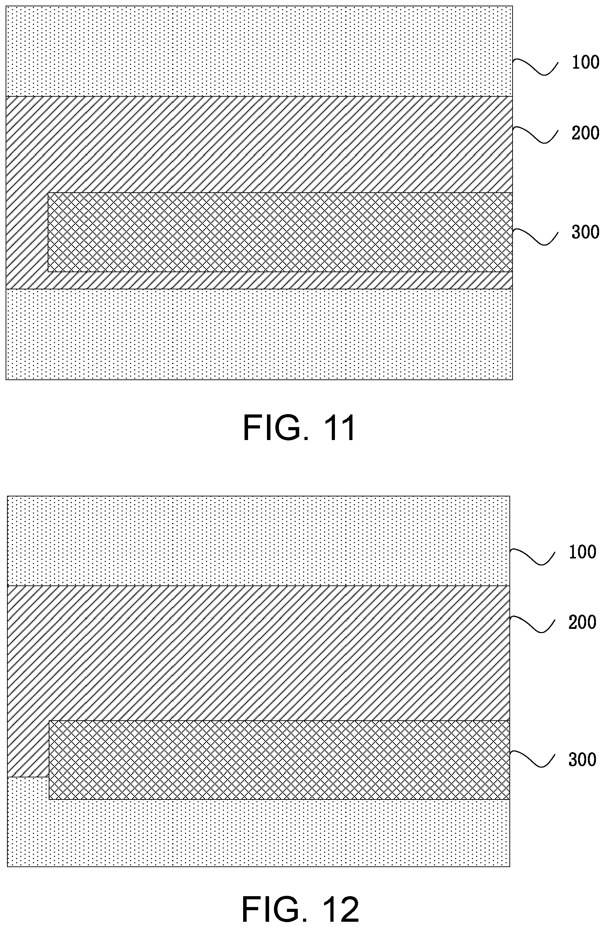

On the basis of FIG. 3 to FIG. 6, as shown in FIG. 11 and FIG. 12, in one of the embodiments, the orthographic projection of the absorption layer 300 on the upper surface of the waveguide layer 200 is at least partially located within the upper surface of the waveguide layer 200.

Specifically, the orthographic projection of the absorption layer 300 on the upper surface of the waveguide layer 200 is entirely located within the upper surface of the waveguide layer 200, as shown in FIG. 11, or is partially located within the upper surface of the waveguide layer 200, as shown in FIG. 12.

In one of the embodiments, the orthographic projection of the absorption layer 300 on the upper surface of the waveguide layer 200 is located within the upper surface of the waveguide layer 200, and the center line of the absorption layer 300 deviates from the center line of the waveguide layer 200, as shown in FIG. 11.

In the above embodiment, the center line of the absorption layer 300 refers to the central axis line along the absorption layer 300. The center line of the waveguide layer 200 refers to the central axis line of the waveguide layer 200. The orthographic projection of the absorption layer 300 on the upper surface of the waveguide layer 200 is entirely located within the upper surface of the waveguide layer 200, and the center line of the absorption layer 300 deviates upward or downward from the center line of the waveguide layer 200.

In the above embodiment, since the light waves are mainly distributed in the middle position in the input waveguide, by changing the positional relationship between the absorption layer 300 and the waveguide layer 200, the orthographic projection of the absorption layer 300 on the upper surface of the waveguide layer 200 is located within the upper surface of the waveguide layer 200, and the center line of the absorption layer 300 is deviated upward or downward from the center line of the waveguide layer 200. In this way, the interaction between the light wave and the absorption layer 300 can be reduced, so that the light energy absorbed by the light incident surface of the photoelectric detector is reduced, and the number of photogenerated carriers distributed is reduced. At the back end, as the total light energy is reduced, on the light wave transmission path, the light absorption and carriers generated are uniformly distributed, thereby the bright light input threshold of the photoelectric detector is improved.

In one of the embodiments, the orthographic projection of the absorption layer 300 on the upper surface of the waveguide layer 200 is partially located within the upper surface of the waveguide layer 200, and the center line of the absorption layer 300 deviates from the center line of the waveguide layer 200, as shown in FIG. 12.

Specifically, the orthographic projection of the absorption layer 300 on the upper surface of the waveguide layer 200 is partially located within the upper surface of the waveguide layer 200, and the center line of the absorption layer 300 deviates upward or downward from the center line of the waveguide layer 200.

In the above embodiment, since the light waves are mainly distributed in the middle position in the input waveguide, by changing the positional relationship between the absorption layer 300 and the waveguide layer 200, the orthographic projection of the absorption layer 300 on the upper surface of the waveguide layer 200 is partially located within the upper surface of the waveguide layer 200, and the center line of the absorption layer 300 is deviated upward or downward from the center line of the waveguide layer 200. In this way, the interaction between the light wave and the absorption layer 300 can be reduced, so that the light energy absorbed by the light incident surface of the photoelectric detector is reduced, and the number of photogenerated carriers distributed is reduced. At the back end, as the total light energy is reduced, on the light wave transmission path, the light absorption and carriers generated are uniformly distributed, thereby the bright light input threshold of the photoelectric detector is improved.

In this embodiment, the positions of the absorption layer 300 and the waveguide layer 200 and the shape of the waveguide layer 200 may be changed simultaneously to control the transmission path of the input light wave at the front end of the detector and reduce the interaction with the absorption material, so that the light energy absorbed by the front end is reduced, the number of photogenerated carriers distributed is reduced, and on the transmission path, the light absorption and carriers generated are uniformly distributed, thereby the bright light input threshold of the detector is improved.

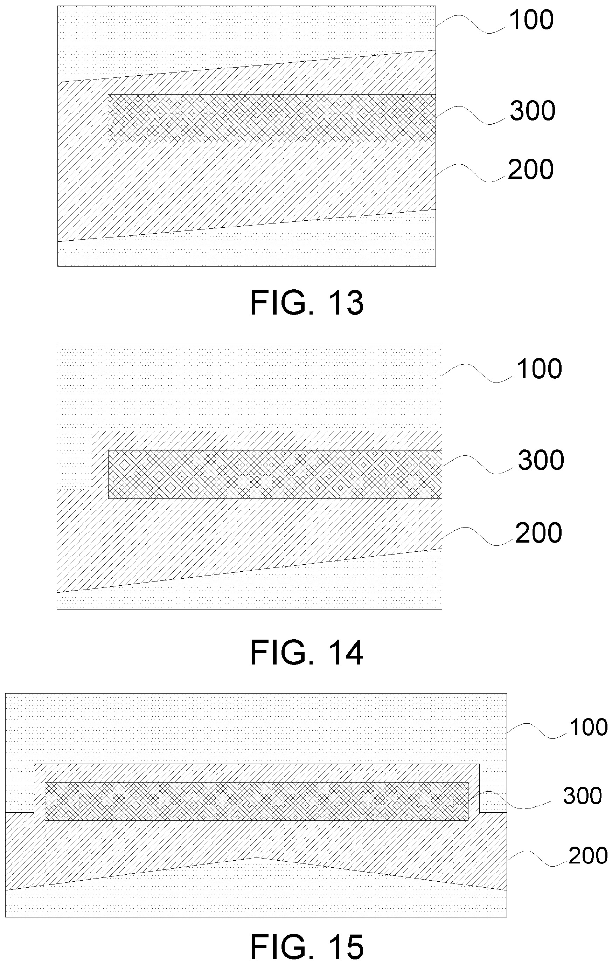

On the basis of FIG. 3 to FIG. 6, as shown in FIG. 13, in one of the embodiments, the waveguide layer 200 is inclined at a preset angle with respect to the extending direction of the absorption layer 300.

Specifically, the waveguide layer 200 is inclined at a preset angle with respect to the extending direction of the absorption layer 300. In this way, by changing the relative positions between the input waveguide layer 200 and the absorption layer 300, the incident light wave does not directly irradiate the absorption material but is gradually absorbed during the transmission process, so that the light energy absorbed by the front end is reduced, as a result, the number of photogenerated carriers distributed is reduced. Therefore, on the transmission path, the light absorption and carriers generated are uniformly distributed, and improving the bright light input threshold of the detector is achieved.

More specifically, the waveguide layer 200 may be inclined at an angle of 5° to 45° with respect to the extending direction of the absorption layer 300, and specifically, may be, for example, 10°, 15°, 20°, 25°, 30°, 35°, or 40°.

In the above embodiment, the positions of the absorption layer 300 and the waveguide layer 200 and the shape of the waveguide layer 200 may be changed simultaneously to control the transmission path of the input light wave at the front end of the detector and reduce the interaction with the absorption material, so that the light energy absorbed by the front end is reduced, the number of photogenerated carriers distributed is reduced, and on the transmission path, the light absorption and carriers generated are uniformly distributed, thereby the bright light input threshold of the detector is improved.

On the basis of FIG. 3 to FIG. 6, as shown in FIG. 14 and FIG. 15, in one of the embodiments, the end surface of the waveguide layer 200 adjacent to the light incident surface is formed in a step shape.

Specifically, at least one end surface of the photoelectric detector is an incident surface, and the end surface of the waveguide layer 200 adjacent to the light incident surface is formed in a step shape. When an end surface of the photoelectric detector is the incident surface, an end surface of the waveguide layer 200 adjacent to the light incident surface is formed in a step shape, as shown in FIG. 14; when both ends of the photoelectric detector are incident surfaces, both end surfaces of the waveguide layer 200 adjacent to the light incident surface are formed in a step shape, as shown in FIG. 15. It should be noted that the end surface of the waveguide layer 200 adjacent to the light incident surface being formed in a step shape here means that the end surface of the waveguide layer 200 adjacent to the light incident surface is formed in a step shape along the width direction, so that different portions of the waveguide layer 200 have different lengths along the width direction.

In this embodiment, the end surface of the waveguide layer 200 adjacent to the light incident surface is formed in a step shape, and the waveguide layer 200 is inclined at a certain angle with respect to the extending direction of the absorption layer 300. Therefore, the incident light wave does not directly irradiate the absorption material but is gradually absorbed during the transmission process, so that the light energy absorbed by the front end is reduced, as a result, the number of photogenerated carriers distributed is reduced, and on the transmission path, the light absorption and carriers generated are uniformly distributed, thereby the bright light input threshold of the detector is improved.

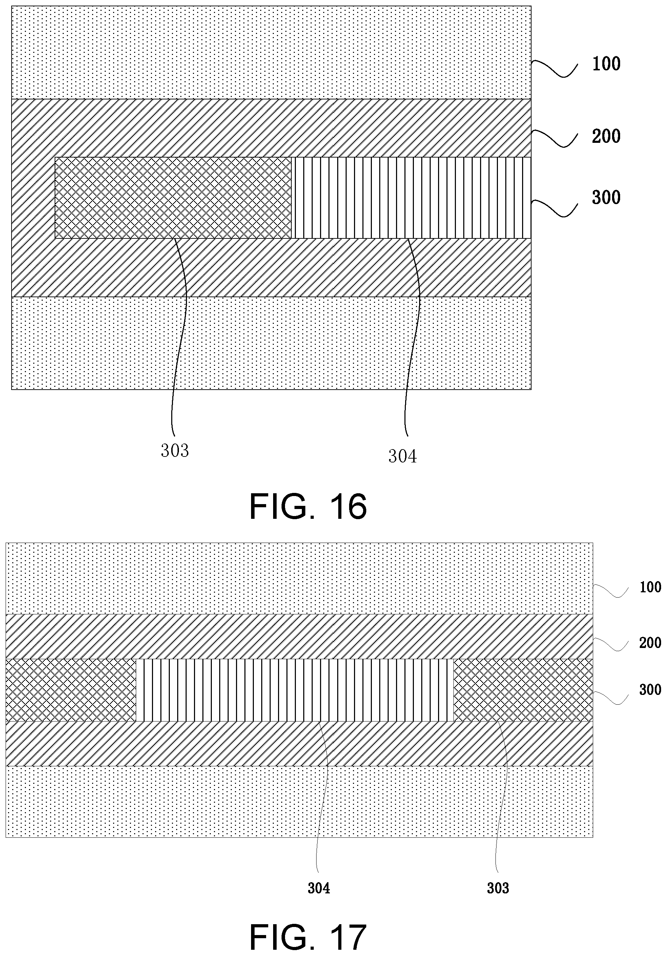

On the basis of FIG. 3 to FIG. 6, as shown in FIG. 16 and FIG. 17, in one of the embodiments, the absorption layer 300 includes: a first absorption layer 303 and a second absorption layer 304, in which the first absorption layer 303 and the second absorption layer 304 are integrally connected and located between the second absorption layer 304 and the light incident surface; the light energy absorption rate of the first absorption layer 303 is lower than the light energy absorption rate of the second absorption layer 304.

Specifically, the absorption layer 300 of the photoelectric detector is located on the waveguide layer 200 or at least partially embedded in the waveguide layer 200; the cladding material 100 covers the top portions and sidewalls of the waveguide layer 200 and the absorption layer 300. In the embodiment, the absorption layer 300 includes: the first absorption layer 303 and the second absorption layer 304. Furthermore, the first absorption layer 303 and the second absorption layer 304 are integrally connected, and the first absorption layer 303 is located between the second absorption layer 304 and the light incident surface, so that the first absorption layer 303 is disposed close to the light incident surface. The light energy absorption rate of the first absorption layer 303 is lower than the light energy absorption rate of the second absorption layer 304.

Specifically, when an end surface of the photoelectric detector is a light incident surface, the absorption layer 300 includes the following: the first absorption layer 303 and the second absorption layer 304 connected in sequence, the first absorption layer 303 and the second absorption layer 304 are integrally connected, and the first absorption layer 303 is located between the second absorption layer 304 and the light incident surface, so that the first absorption layer 303 is disposed close to the light incident surface, that is, an end of the second absorption layer 304 is connected to the first absorption layer 303, as shown in FIG. 16. When both ends of the photoelectric detector are light incident surfaces, the absorption layer 300 includes the following: the first absorption layer 303, the second absorption layer 304, and the first absorption layer 303 connected in sequence, the first absorption layer 303 and the second absorption layer 304 are integrally connected, and the first absorption layer 303 is located at two ends of the second absorption layer 304, so that the first absorption layer 303 is respectively adjacent to the light incident surfaces at two ends of the photoelectric detector; that is, two opposite ends of the second absorption layer 304 are both connected to the first absorption layer 303, as shown in FIG. 17.

In this embodiment, the first absorption layer 303 and the second absorption layer 304 are made of absorption materials with different absorption coefficients, and the first absorption layer 303 is located at two ends of the second absorption layer 304, so that the first absorption layer 303 is respectively adjacent to the light incident surfaces at two ends of the photoelectric detector. The first absorption layer 303 is made of low absorption material, and the second absorption layer 304 is made of high absorption material, so that the light energy absorbed by the front end of the photoelectric detector is reduced, the number of photogenerated carriers distributed is reduced, and on the transmission path, the light absorption and carriers generated are uniformly distributed, thereby the bright light input threshold of the detector is improved.

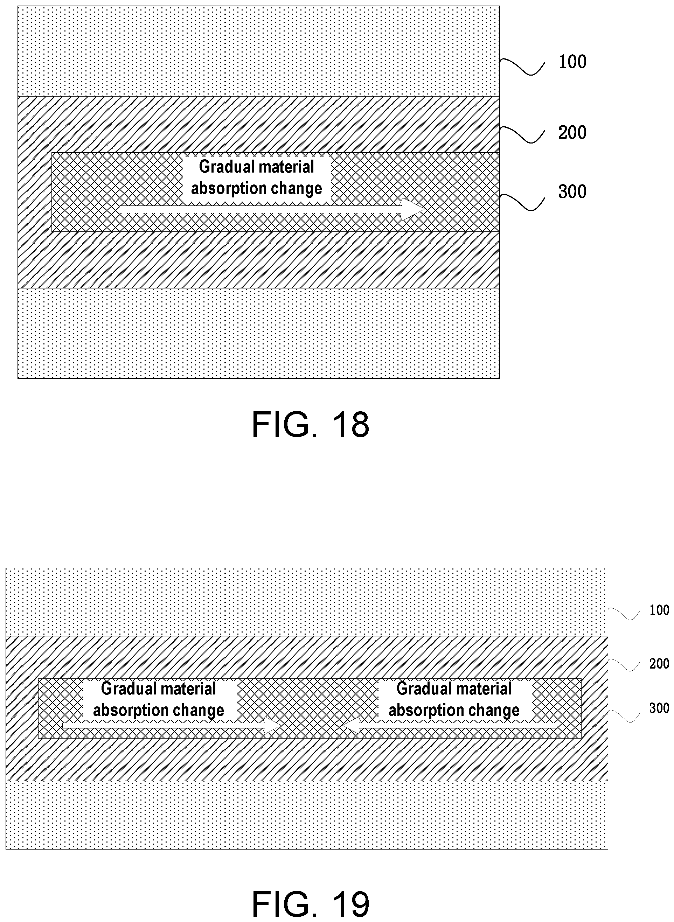

On the basis of FIG. 3 to FIG. 6, as shown in FIG. 18 and FIG. 19, in one of the embodiments, the light energy absorption rate of the absorption layer 300 gradually increases from the light incident surface to a direction away from the light incident surface.

Specifically, the absorption layer 300 of the photoelectric detector is located on the waveguide layer 200 or at least partially embedded in the waveguide layer 200; the cladding material 100 covers the top portions and sidewalls of the waveguide layer 200 and the absorption layer 300. The light energy absorption rate of the absorption layer 300 gradually increases from the light incident surface toward a direction away from the light incident surface.

Specifically, when an end surface of the photoelectric detector is the light incident surface, the light energy absorption rate of the absorption layer 300 gradually increases from the light incident surface toward another end surface away from the light incident surface, as shown in FIG. 18. When both ends of the photoelectric detector are light incident surfaces, the light energy absorption rate of the absorption layer 300 gradually increases from the light incident surfaces at two ends toward the middle of the photoelectric detector, as shown in FIG. 19.

In this embodiment, the absorption layer 300 is made of a material with a gradient absorption rate, and the light energy absorption rate of the absorption layer 300 gradually increases from the light incident surface toward a direction away from the light incident surface. Therefore, the light energy absorbed by the front end is reduced, the number of photogenerated carriers distributed is reduced, and on the transmission path, the light absorption and carriers generated are uniformly distributed, thereby the bright light input threshold of the detector is improved.

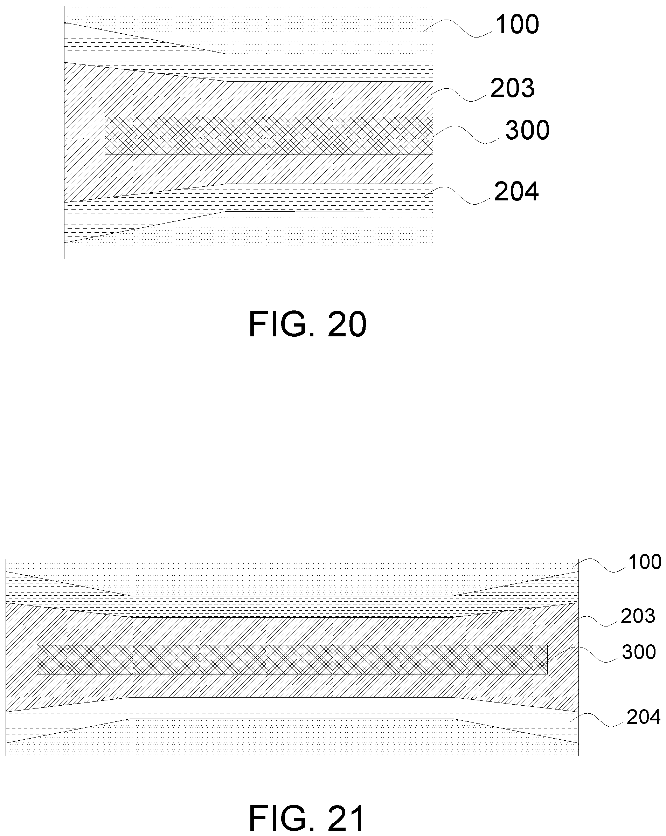

On the basis of FIG. 3 to FIG. 6, as shown in FIG. 20 and FIG. 21, in one of the embodiments, the waveguide layer 200 includes the following: a first waveguide layer 204 and a second waveguide layer 203 are provided, the second waveguide layer 203 is embedded in the first waveguide layer 204, the upper surface of the second waveguide layer 203 is higher than the upper surface of the first waveguide layer 204, and the absorption layer 300 is located on the upper surface of the second waveguide layer 203 or is at least partially embedded in the second waveguide layer 203.

Specifically, the absorption layer 300 of the photoelectric detector is located on the waveguide layer 200 or at least partially embedded in the waveguide layer 200; the cladding material 100 covers the top portions and sidewalls of the waveguide layer 200 and the absorption layer 300. In the embodiment, the waveguide layer 200 includes: the first waveguide layer 204 and the second waveguide layer 203. The second waveguide layer 203 is embedded in the first waveguide layer 204, the upper surface of the second waveguide layer 203 is higher than the upper surface of the first waveguide layer 204, and the absorption layer 300 is located on the upper surface of the second waveguide layer 203 or is at least partially embedded in the second waveguide layer 203.

Specifically, the materials of the first waveguide layer 204 and the second waveguide layer 203 may be the same or different. Through the multi-layer waveguide material structure with different heights, controlling uniform absorption and distribution of the incident light is achieved, thereby the bright light input threshold of the detector is improved.

More specifically, the width of the end surface of the first waveguide layer 204 adjacent to the light incident surface is greater than the width of other portions of the first waveguide layer 204, the width of the end surface of a second waveguide layer 205 adjacent to the light incident surface is greater than the width of other portions of the second waveguide layer 205, furthermore, the width of the first waveguide layer 204 and the minimum width of the second waveguide layer 205 are both greater than the width of the absorption layer 300.

It should be noted that the schematic structural diagram of the longitudinal cross-section of the photoelectric detector in embodiments refers to the schematic structural diagram of the longitudinal cross-section taken along the thickness direction of the photoelectric detector, and the schematic structural diagram of the cross-section of the photoelectric detector refers to the schematic structural diagram of the cross-section taken parallel to the upper surface of the photoelectric detector.

In the description of this specification, the description referring to terms such as "some embodiments", "other embodiments", and "ideal embodiments", means that the specific features, structures, materials, or characteristics described together with the embodiment or example are included in at least one of the embodiments or examples of the present invention. In this specification, the illustrative descriptions of the above terms do not necessarily refer to the same embodiment or example.

The technical features of the embodiments may be combined arbitrarily. For the clarity of the description, not all possible combinations of the technical features of the embodiments are described. However, as long as there is no contradiction in combinations of these technical features, the combinations should be considered to be within the scope of this specification.

The embodiments merely express several implementation manners of the present application, and the description thereof is relatively specific and detailed, but should not be construed as limiting the scope of the patent application. It should be pointed out that, for ordinary technicians in this field, several modifications and improvements may be made without departing from the concept of the present application, which all fall within the scope of protection of the present application. Therefore, the scope of protection of this patent application should be based on the appended claims.

## Claims

1. A photoelectric detector, comprising:
a waveguide layer;
an absorption layer, located on an upper surface of the waveguide layer or at least partially embedded in the waveguide layer; and
a cladding material, covering top portions and side walls of the waveguide layer and the absorption layer,
wherein at least one end surface of the photoelectric detector is a light incident surface, and a thickness of an end surface of the absorption layer adj acent to the light incident surface is smaller than a thickness of other portions of the absorption layer.

2. The photoelectric detector according to claim 1, wherein a thickness of the waveguide layer is greater than a thickness of the cladding material.

3. The photoelectric detector according to claim 1, wherein a width of an end surface of the absorption layer adj acent to the light incident surface is smaller than a width of other portions of the absorption layer.

4. The photoelectric detector according to claim 1, wherein a width of an end surface of the waveguide layer adj acent to the light incident surface is greater than a width of other portions of the waveguide layer.

5. The photoelectric detector according to claim 1, wherein an orthographic projection of the absorption layer on an upper surface of the waveguide layer is at least partially located within the upper surface of the waveguide layer.

6. The photoelectric detector according to claim 5, wherein the orthographic projection of the absorption layer on the upper surface of the waveguide layer is located within the upper surface of the waveguide layer, and a center line of the absorption layer is deviated from a center line of the waveguide layer.

7. The photoelectric detector according to claim 5, wherein the orthographic projection of the absorption layer on the upper surface of the waveguide layer is partially located within the upper surface of the waveguide layer, and a center line of the absorption layer is deviated from a center line of the waveguide layer.

8. The photoelectric detector according to claim 1, wherein the waveguide layer is inclined at a preset angle with respect to an extending direction of the absorption layer.

9. The photoelectric detector according to claim 1, wherein an end surface of the waveguide layer adjacent to the light incident surface is formed in a step shape.

10. The photoelectric detector according to claim 1, wherein the absorption layer comprises a first absorption layer, and a second absorption layer, the first absorption layer and the second absorption layer are integrally connected, the first absorption layer is located between the second absorption layer and the light incident surface, and a light energy absorption rate of the first absorption layer is lower than a light energy absorption rate of the second absorption layer.

11. The photoelectric detector according to claim 1, wherein a light energy absorption rate of the absorption layer is gradually increased along a direction away from the light incident surface.

12. The photoelectric detector according to claim 1, wherein the waveguide layer comprises a first waveguide layer, and a second waveguide layer, the second waveguide layer is embedded in the first waveguide layer, an upper surface of the second waveguide layer is higher than an upper surface of the first waveguide layer, and the absorption layer is located on the upper surface of the second waveguide layer or is at least partially embedded in the second waveguide layer.
